# EUROPEAN PATENT APPLICATION

(11) **EP 4 672 681 A1**
(43) Date of publication of application: **31.12.2025**
(21) Application number: 24184013.1
(22) Date of filing: 24.06.2024
(51) Int. Cl.: H04L 25/02, H03K 5/08

(54) **METHOD FOR AND ETHERNET PHYSICAL LAYER TRANSCEIVER WITH ADAPTIVE COMMON-MODE DISTURBANCE COMPENSATION IN ETHERNET PHYSICAL LAYERS**

(71) Applicant: Siliconally GmbH, 01067 Dresden (DE)
(72) Inventor: Kreißig, Martin, 01067 Dresden (DE); Hänzsche, Stefan, 01067 Dresden (DE); Höppner, Sebastian, 01067 Dresden (DE); Onat, Emrah, 01067 Dresden (DE)
(74) Representative: Lippert Stachow Patentanwälte Rechtsanwälte Partnerschaft mbB

(57) **Abstract**

The invention relates to a method for adaptive common-mode disturbance compensation in ethernet physical layers, comprising the steps of:
measuring a voltage signal of a media dependent interface of the ethernet physical layer;
generating an output voltage signal based on the measured voltage signal of the media dependent interface;
providing the output voltage signal and a reference voltage signal to at least two identical transconductance circuits,
which are connected together to the media dependent interface, wherein each transconductance circuit:
compares the output voltage signal with the reference voltage signal,
generates a compensation current signal based on the result of the comparison of the output voltage signal with the reference voltage signal, and
provide the compensation current signal to the media dependent interface; and

selectively enabling and/or disabling one or more of the at least two transconductance circuits, until the output voltage signal equals to the reference voltage signal.

## Description

The invention relates to a method for adaptive common-mode disturbance compensation in ethernet physical layers. The invention further relates to an ethernet physical layer transceiver with adaptive common-mode disturbance compensation in ethernet physical layers.

This invention relates to the field of automotive ethernet transceivers, to common-mode disturbance compensation, also referred to common-mode clamping (CMC) circuits and more particularly to circuits and methods for adaptivity in common-mode clamping. For stabilizing common-mode voltage at differential signal lines, the common-mode clamping circuit can be composed as feedback transconductance amplifier by comparing the common-mode voltage to a reference and injecting equal currents into each of the differential signal lines to counteract common-mode voltage disturbances.

From the state of the art, it is known that common-mode disturbance on the media dependent interface (MDI) can be suppressed by common-mode clamping devices that measure the common-mode voltage and inject a current for common-mode compensation.

US20150303907A1 consists of two circuits. First circuit is used for sensing a voltage signal across clamp terminals and to generate an output voltage signal based on the sensed voltage signal (e.g. transconductance amplifier). The second circuit compares the output voltage signal with a reference voltage. It generates an equal pair of current signals based on a result of comparison. This approach is suffering from constant power consumption e.g. needed for bias generation especially when operating the transconductance amplifier in class A or AB mode. Also, in case of high current driving capability impact on signal integrity is expected due to the capacitive load represented by large transistors constantly biased and connected to the signal lines.

According to US10128824B2, a mean value between the first end and the second end is referred to as a value of a common-mode signal associated with the differential signal. The common-mode signal is typically undesirable and generally should be suppressed. A common-mode clamp is a circuit that is configured to suppress (or clamp) a common-mode signal of a differential circuit. A common-mode clamp usually needs to sense a value of the common-mode signal, and then perform the suppression based on the sensed value. What is disclosed is a method for clamping a common-mode signal without needing a circuit to sense the common-mode signal. This circuit is lacking from the existence of an accurate common-mode reference to compare to. Because of this and the rather low gain provided by the single stage amplifier concept this circuit is capable to react on only large common-mode variations which might already disturb the differential signalling in case of limited dynamic range as in low voltage designs.

It is an object of the present invention to provide an adaptive common-mode disturbance compensation in ethernet physical layers, including the detection of the common mode disturber event and strength. Furthermore, the DC power consumption should be reduced, and the signal integrity should be improved compared to a static (non-adaptive) implementation.

The object is solved according to the invention by a method according to claim 1 and an ethernet physical layer transceiver according to claim 9. Preferred embodiments of the invention are defined in the dependent claims.

The invention relates to a method for adaptive common-mode disturbance compensation in ethernet physical layers, comprising the steps of:
measuring a voltage signal of a media dependent interface of the ethernet physical layer;
generating an output voltage signal based on the measured voltage signal of the media dependent interface;
providing the output voltage signal and a reference voltage signal to at least two identical transconductance circuits, which are connected in parallel to the media dependent interface, wherein each transconductance circuit:
   compares the output voltage signal with the reference voltage signal,
   generates a compensation current signal based on the result of the comparison of the output voltage signal with the reference voltage signal, and
   provide the compensation current signal to the media dependent interface; and
selectively enabling and/or disabling one or more of the at least two transconductance circuits, until the output voltage signal equals to the reference voltage signal.

The invention bases on the known principle that common-mode disturbance on the media dependent interface (MDI) can be suppressed by common-mode compensation by measuring the common-mode voltage and inject a current for common-mode compensation.

In contrast to the prior art, the invention bases on using at least two identical transconductance circuits, which are connected in parallel to the media dependent interface. Preferably, N identical transconductance circuits are connected in parallel to the media dependent interface. Each of the transconductance circuits compares the output voltage signal with the reference voltage signal, generates a compensation current signal based on the result of the comparison of the output voltage signal with the reference voltage signal, and provides the compensation current signal to the media dependent interface.

According to the present invention, one or more of the at least two transconductance circuits are selectively enabling and/or disabling, until the output voltage signal equals to the reference voltage signal. Only the enabled transconductance circuits generate and provide the compensation signal to the media dependent interface, while the disabled transconductance circuits have no function respectively do not provide a compensation signal to the media dependent interface.

Hence, the invention uses at least two, preferably N, equal transconductance amplifier or also referred to as transconductance amplifier cells or (transconductance amplifier) slices in parallel which can be activated/deactivated individually. So, it can adapt the common-mode clamping (compensation signal) strength by adjusting the number of active slices. This reduces DC power consumption and aging of slices. The strength of a present or past common-mode disturbance can be classified. Also, it leads to reduction of input capacitances at differential signal lines and hence increased return loss to fix a reduced return loss issue.

Common-mode compensation strength can be adapted over time according to the disturber strength since the level of possible injected common-mode disturbances is not constant over time and also rather unspecific. This is done by enabling/disabling the one or more of the identical transconductance circuits.

In a variant of the invention, an enabled transconductance circuit generates a clipping signal when the transconductance circuit is saturated, wherein this clipping signal is used to enable a further transconductance circuit, which is currently disabled. Using the clipping signals further transconductance circuits are enabled until the output voltage signal equals the reference voltage signal or until a threshold number of transconductance circuits is enabled. The threshold number of transconductance circuits must not correspond to the total number of available transconductance circuits but can also be lower.

According to a preferred variant of the invention, the transconductance circuit is a feedback transconductance amplifier that compares the output voltage signal with the reference voltage signal and generates the compensation current signal. Using a feedback transconductance amplifier the transconductance circuit can be easily implemented with minimal cost and chip size.

Pursuant to a variant of the invention, the method comprises the step of defining a threshold number of enabled transconductance circuits and generating an event or storing an event in a database for later readout if the number of enabled transconductance circuits exceeds threshold number, wherein the threshold number is smaller than the total number of available transconductance circuits.

In an expedient variant of the invention, at least one transconductance circuit is enabled at all times. This at least one transconductance circuit is used for compensating common-mode disturbances and activate further transconductance circuits, for example by generating a corresponding clipping signal.

According to an advantageous variant of the invention, each transconductance circuit has a unique index and the index of enabled transconductance circuits are stored in a FIFO register according to their sequence of enabling. In this way the transconductance circuits are activated sequentially and hence the reduced excessive aging of individual transconductance circuits.

Pursuant to a variant of the invention, an interrupt signal is generated if the number of enabled transconductance circuits is equal to the number of available transconductance circuits. Once the total number of available transconductance circuits is activated the current common-mode compensation method has reached its maximum compensation capabilities and this results in an interrupt signal to inform the higher-level processes of a problem with high disturbances on the ethernet physical layer.

In a preferred variant of the invention, the method comprises the further step of starting a counter after a transconductance circuit has been enabled and disabling a transconductance circuit if no further transconductance circuit is enabled until the counter expires and at least two transconductance circuits are enabled. Using this counter, activated transconductance circuits will be sequentially deactivated if they are no longer needed for common-mode disturbance compensation. For example, using the counter the number of active transconductance circuits is sequentially reduced if the common-mode disturbances have decreased and could be compensated by a smaller number of transconductance circuits.

The invention further relates to an ethernet physical layer transceiver with adaptive common-mode disturbance compensation in ethernet physical layers, comprising:
a first circuit connected to a media dependent interface of the ethernet physical layer and configured
   to measure a voltage signal across the media dependent interface and
   to generate an output voltage signal based on the measured voltage signal;
at least two identical transconductance circuits, which are connected in parallel to the media dependent interface and to the first circuit, wherein the transconductance circuits are each configured to:
   receive the output voltage signal from the first circuit and compare the output voltage signal with a reference voltage signal,
   generate a compensation current signal based on the result of the comparison of the output voltage signal with the reference voltage signal,
   provide the compensation current signal to the media dependent interface, and
   generate clipping signal when the transconductance circuit is saturated,
   each transconductance circuit further comprising an enable input for being selectively enabled or disabled;
an adaptive control unit connected to all transconductance circuits for receiving clipping signals from and sending enable/disable signal to respective transconductance circuits, wherein the adaptive control unit is configured to implement the method according to the present invention by adjusting the number of active transconductance circuits by sending enable/disable signals to selected transconductance circuits.

In a preferred variant of the invention, the transconductance circuit is a feedback transconductance amplifier.

In the following the invention will be explained further with respect to embodiments shown in the attached figures. It shows:
- Fig. 1: a schematic diagram of an ethernet physical layer transceiver with adaptive common-mode disturbance compensation in ethernet physical layers according to the present invention;
- Fig. 2: an exemplary flow diagram of a method for adaptive common-mode disturbance compensation in ethernet physical layers according to an embodiment of the invention; and
- Fig. 3: different states, counters and registers with respect to the embodiment of the method for adaptive common-mode disturbance compensation in ethernet physical layers of Fig. 2.

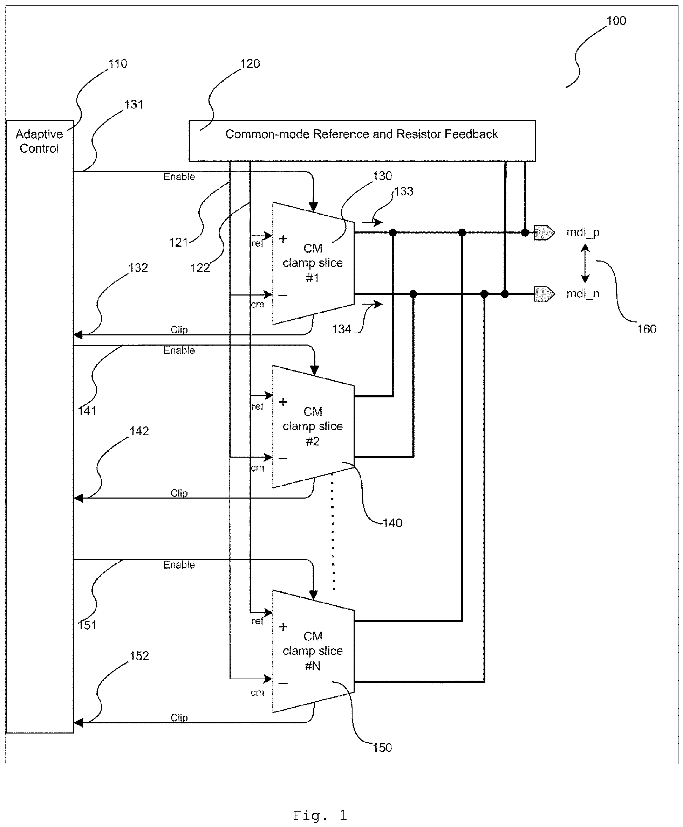

Fig. 1 shows a schematic diagram of an ethernet physical layer transceiver 100 with adaptive common-mode disturbance compensation in ethernet physical layers according to the present invention.

The ethernet physical layer transceiver 100 shown in Fig. 1 comprises a control unit 110, a first circuit 120 and N identical transconductance circuits 130, 140, 150.

The first circuit 120 is connected to a media dependent interface 160 of the ethernet physical layer and is configured to measure a voltage signal across the media dependent interface 160 and to generate an output voltage 121 signal based on the measured voltage signal.

The N identical transconductance circuits 130, 140, 150 are connected in parallel to the media dependent interface 160 and to the first circuit 120. The N identical transconductance circuits 130, 140, 150 each receive the output voltage signal 121 from the first circuit 120 and compare the output voltage signal 121 with a reference voltage signal 122. According to the embodiment of Fig. 1, the reference voltage signal 122 is also provided by the first circuit 120. The N identical transconductance circuits 130, 140, 150 are configured to generate a compensation current signal 133, 134 based on the result of the comparison of the output voltage signal 121 with the reference voltage signal 122. The compensation current signal 133, 134 can be provided to the media dependent interface 160 by the N identical transconductance circuits 130, 140, 150. Furthermore, each transconductance circuit 130, 140, 150 further comprising an enable input for being selectively enabled or disabled by an enable signal 131, 141, 151 of the control unit 110. In case a transconductance circuit 130, 140, 150 is saturated, it generates a clipping signal 132, 142, 152 for the control unit 110.

Hence, the adaptive control unit 110 is connected to all transconductance circuits 130, 140, 150 for receiving clipping signals 132, 142, 152 from and sending enable/disable signals 131, 141, 151 to respective transconductance circuits 130, 140, 150. The control unit 110 can therefore adjust the number of active transconductance circuits 130, 140, 150 by sending enable/disable signals 131, 141, 151 to selected transconductance circuits 130, 140, 150.

For example, one of the transconductance circuits 130, 140, 150 (e.g., 130) that is selected arbitrarily by adaptive control unit 110 with enable signal 131 compares the output voltage 121 with the reference voltage 122 and generates a pair of current signals 133 and 134 based on a result of the comparison. Adaptive control unit 110 activates or deactivates the transconductance circuits 130, 140, 150 by using enable signals 131, 141, 151 with the help of clipping signals 132, 142, 152, i.e. if the enabled transconductance circuits are saturated, respective clipping signals 132, 142, 152 are generated, which cause the control unit 110 to send an enable signal 131, 141, 151 to a further, currently deactivated, transconductance circuit 130, 140, 150.

In general, the control unit 110 is configured to implement the following method for adaptive common-mode disturbance compensation in ethernet physical layers, comprising the steps of:
measuring a voltage signal of a media dependent interface 160 of the ethernet physical layer;
generating an output voltage 121 signal based on the measured voltage signal of the media dependent interface 160;
providing the output voltage signal 121 and a reference voltage signal 122 to at least two identical transconductance circuits 130, 140, 150, which are connected in parallel to the media dependent interface 160, wherein each transconductance circuit 130, 140, 150:
   compares the output voltage signal 121 with the reference voltage signal 122,
   generates a compensation current signal 133, 134 based on the result of the comparison of the output voltage signal 121 with the reference voltage signal 122, and
   provide the compensation current signal 133, 134 to the media dependent interface 160; and
selectively enabling and/or disabling one or more of the at least two transconductance circuits 130, 140, 150, until the output voltage signal 121 equals to the reference voltage signal 21.

As already described above, an enabled transconductance circuit 130, 140, 150 generates a clipping signal 132, 142, 152 when the transconductance circuit 130, 140, 150 is saturated, wherein this clipping signal 132, 142, 152 is used to enable a further transconductance circuit 130, 140, 150, which is currently disabled.

Preferably, a counter is started after a transconductance circuit 130, 140, 150 has been enabled. One of the enabled transconductance circuits 130, 140, 150 is disabled if no further transconductance circuit 130, 140, 150 is enabled until the counter expires and at least two transconductance circuits 130, 140, 150 are enabled. Hence, at least one transconductance circuit 130, 140, 150 is enabled at all times.

In an advantageous variant of the invention, the transconductance circuit 130, 140, 150 is a feedback transconductance amplifier that compares the output voltage signal 121 with the reference voltage signal 122 and generates the compensation current signal 133, 134.

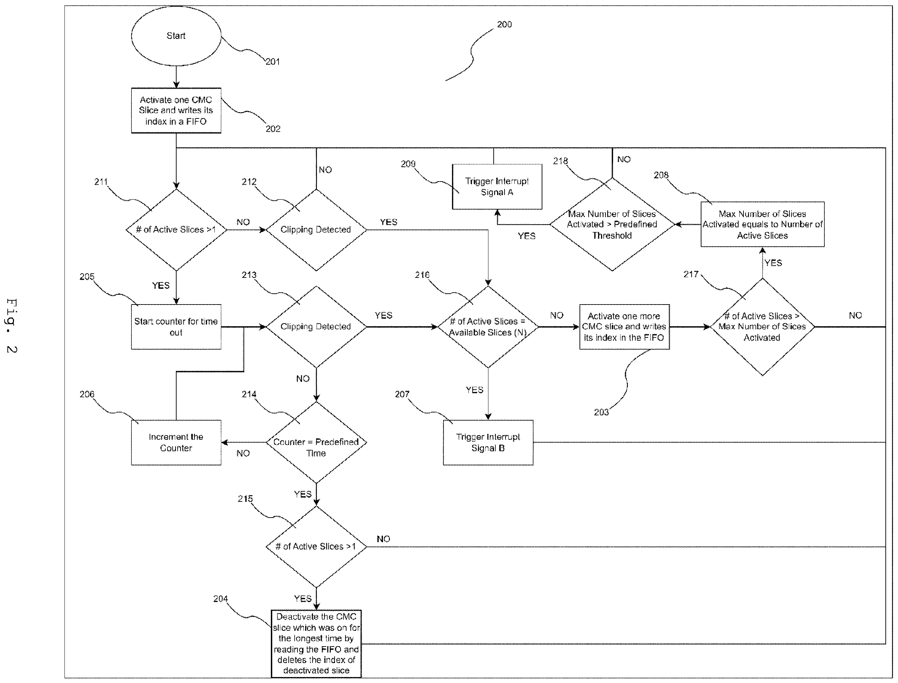

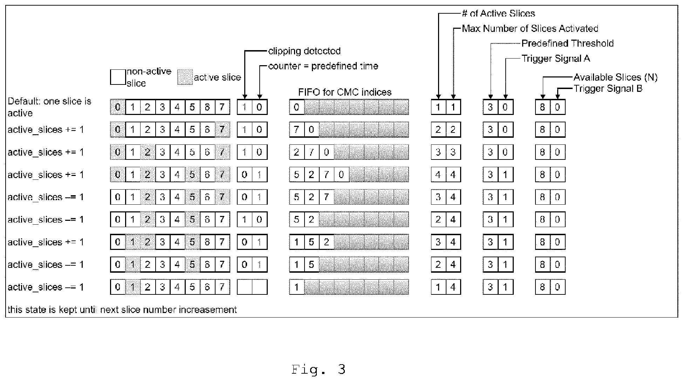

Fig. 2 shows an exemplary flow diagram of a method 200 for adaptive common-mode disturbance compensation in ethernet physical layers according to an embodiment of the invention. Fig. 3 shows different states, counters and registers with respect to the embodiment of the method for adaptive common-mode disturbance compensation in ethernet physical layers of Fig. 2.

According to this embodiment in total eight transconductance circuits 130, 140, 150 are available. Furthermore, a threshold number of enabled transconductance circuits 130, 140, 150 is defined and set to three. An event is generated or stored in a database for later readout if the number of enabled transconductance circuits 130, 140, 150 exceeds threshold number. The threshold number of three is smaller than the total number of available transconductance circuits 130, 140, 150, which is eight. Each transconductance circuit 130, 140, 150 of the embodiment of Fig. 2 has a unique index and the index of enabled transconductance circuits 130, 140, 150 are stored in a FIFO register according to their sequence of enabling.

The adaptive common-mode compensation/clamp (CMC) algorithm 200 shown in Fig. 2 Comprises the following steps:
1. Start (201)
2. At least one transconductance circuit 130, 140, 150 (CMC slice) has to be active. So, adaptive control unit 110 selects one arbitrary transconductance circuit 130, 140, 150 to activate 202 and writes its index in a FIFO (First In First Out) with lengths equals to number of active transconductance circuits 130, 140, 150. (For Algorithm Scenario in Fig. 3: CMC #0 is the first active slice, # of Active Slices =1, Maximum Number of Slices Activated = 1)
3. At the beginning there is just one active transconductance circuit 130, 140, 150, so adaptive control unit 110 waits for clipping signal 132, 142, 152 to activate one more transconductance circuit 130, 140, 150.
   a. If there is still a difference between output voltage signal 121 and the reference voltage 122, the first transconductance circuit 130, 140, 150 will be saturated and it will generate clipping signal 132, 142, 152.
   b. When clipping signal 132, 142, 152 is detected 212 in adaptive control unit 110:
      i. If the number of active transconductance circuits 130, 140, 150 is equal to total number of available transconductance amplifiers 130, 140, 150 (N) 216, an interrupt Signal B is triggered 207. (Fig. 3: Trigger Signal B is 0)
      ii. If number of active transconductance circuits 130, 140, 150 is not equal to total number of Available Slices (N) 216, one more transconductance circuit 130, 140, 150 will be activated 203 and its index is written in the FIFO. (Fig. 3: CMC #7 is the new active slice, # of Active Slices is 2)
   c. After activation of a transconductance circuit 130, 140, 150 in step 203; if the number of active transconductance circuits 130, 140, 150 is higher than a counter 'Maximum Number of Slices Activated' 217, the counter 'Maximum Number of Slices Activated' is set to the number of active transconductance circuits 130, 140, 150 (step 208). (Fig. 3: Maximum Number of Slices Activated changes from 1 to 2).
   d. If counter 'Maximum Number of Slices Activated' is higher than threshold number 'Predefined Threshold Value' 218, an interrupt Signal A is triggered in step 209. (Fig. 3: Trigger Signal A is 0)
4. There are 2 active transconductance circuits 130, 140, 150 (step 211). So, adaptive control unit 110 has to start counting 205 in order to deactivate one transconductance circuit 130, 140, 150 if there is no detected clipping signal 132, 142, 152.
   a. If there is still a difference between output voltage signal 121 and the reference voltage 122, the second activated transconductance circuit 130, 140, 150 will be saturated and it will generate clipping signal 142.
   b. When clipping signal 142 is detected 213 in adaptive control unit 110:
      i. If the number of active transconductance circuits 130, 140, 150 is equal to total number of available transconductance circuits 130, 140, 150 (N) (step 216), interrupt Signal B is triggered (step 207).
      ii. If number of active transconductance circuits 130, 140, 150 is not equal to total number of available transconductance circuits 130, 140, 150 (N) (step 216), one more transconductance circuit 130, 140, 150 will be activated (step 203) and its index is written in the FIFO. (Fig. 3: CMC #2 is the new active slice, # of Active Slices is 3)
   c. After activation of a transconductance circuit 130, 140, 150 (step 203); if the number of active transconductance circuits 130, 140, 150 is higher than counter 'Maximum Number of Slices Activated' (step 217), counter 'Maximum Number of Slices Activated' is set to number of active transconductance circuits 130, 140, 150 (208). (Fig. 3: Maximum Number of Slices Activated changes from 2 to 3)
   d. If counter 'Maximum Number of Slices Activated' is higher than threshold value 'Predefined Threshold Value' (step 218), an interrupt Signal A is triggered (step 209). (Fig. 3: Trigger Signal A is 0)
5. There are 3 active transconductance circuits 130, 140, 150 (step 211). So, adaptive control unit has to start counting (205) again from zero in order to deactivate one transconductance circuit 130, 140, 150 if there is no detected clipping signal.
   a. If there is still a difference between output voltage signal 121 and reference voltage 122, the third activated transconductance circuit 130, 140, 150 will be saturated and it will generate clipping signal 152.
   b. When clipping signal 142 is detected (step 213) in adaptive control unit 110:
      i. If the number of active transconductance circuits 130, 140, 150 is equal to total number of available transconductance circuits 130, 140, 150 (N) (step 216), interrupt Signal B is triggered (step 207).
      ii. If number of active transconductance circuits 130, 140, 150 is not equal to total number of available transconductance circuits 130, 140, 150 (N) (step 216), one more transconductance circuit 130, 140, 150 will be activated (step 203) and its index is written in the FIFO. (Fig. 3: CMC #5 is the new active slice, # of Active Slices is 4)
   c. After activation of a transconductance circuit 130, 140, 150 (step 203); if the number of active transconductance circuits 130, 140, 150 is higher than counter 'Maximum Number of Slices Activated' (step 217), counter 'Maximum Number of Slices Activated' is set to number of active transconductance circuit 130, 140, 150 (step 208). (Fig. 3: Maximum Number of Slices Activated changes from 3 to 4)
   d. If counter 'Maximum Number of Slices Activated' is higher than threshold number 'Predefined Threshold Value' (step 218), interrupt Signal A is triggered (step 209). (Fig. 3: Trigger Signal A is 1)
6. There are four active transconductance circuits 130, 140, 150 (step 211). So, adaptive control unit 110 has to start counting (step 205) again from zero in order to deactivate one of the transconductance circuits 130, 140, 150 if there is no detected clipping signal 132, 142, 152.
   a. If there is no difference between output voltage signal 121 and reference voltage 122, no transconductance circuit 130, 140, 150 will be saturated and they will not generate clipping signal 132, 142, 152.
   b. When clipping signal 132, 142, 152 is not detected (step 213) in adaptive control unit 110, it increments the counter (step 206).
   c. When the counter is equal to predefined value (214),
      i. If the number of active transconductance circuits 130, 140, 150 is higher than one (step 215), adaptive control unit 110 will deactivate a transconductance circuit 130, 140, 150 (step 204) which was on for the longest time by reading the FIFO and deletes the index of deactivated transconductance circuit 130, 140, 150. (Fig. 3: CMC #0 is the slice to be deactivated firstly)
7. There are 3 active transconductance circuits 130, 140, 150 (step 211). So, adaptive control unit 110 has to start counting (step 205) again from zero in order to deactivate one transconductance circuit 130, 140, 150 if there is no detected clipping signal 132, 142, 152.
   a. If there is no difference between output voltage signal 121 and reference voltage 122, no transconductance circuit 130, 140, 150 will be saturated and they will not generate clipping signal 132, 142, 152.
   b. When clipping signal 132, 142, 152 is not detected (step 213) in adaptive control unit 110, it increments the counter (step 206).
   c. When the counter is equal to predefined value (step 214),
      i. If the number of active transconductance circuits 130, 140, 150 is higher than one (step 215), adaptive control unit 110 will deactivate one transconductance circuit 130, 140, 150 (step 204) which was on for the longest time by reading the FIFO and deletes the index of deactivated transconductance circuit 130, 140, 150. (Fig. 3: CMC #7 is the slice to be deactivated secondly)
8. There are two active transconductance circuits 130, 140, 150 (step 211). So, adaptive control unit 110 has to start counting (step 205) again from zero in order to deactivate one transconductance circuit 130, 140, 150 if there is no detected clipping signal 132, 142, 152.
   a. If there is still a difference between output voltage signal 121 and reference voltage 122, one of the activated transconductance circuits 130, 140, 150 will be saturated and it will generate clipping signal 132, 142, 152.
   b. When clipping signal 132, 142, 152 is detected (step 213) in adaptive control unit 110,
      i. If the number of active transconductance circuits 130, 140, 150 is equal to total number of available transconductance circuits 130, 140, 150 (N) (step 216), interrupt Signal B is triggered (step207).
      ii. If number of active transconductance circuits 130, 140, 150 is not equal to total number of available transconductance circuits 130, 140, 150 (N) (step 216), one more transconductance circuit 130, 140, 150 will be activated (step 203) and its index is written in the FIFO. (Fig. 3: CMC #1 is the new active slice, # of Active Slices is 3)
   c. After activation of a transconductance circuit 130, 140, 150 (step 203); if the number of active transconductance circuits 130, 140, 150 is higher than counter 'Maximum Number of Slices Activated' (step 217), counter 'Maximum Number of Slices Activated' is set to number of active transconductance circuits 130, 140, 150 (step 208). (Fig. 3: Maximum Number of Slices Activated is still 4)
   d. If counter 'Maximum Number of Slices Activated' is higher than threshold number 'Predefined Threshold Value' (step 218), interrupt Signal A is triggered (209). (Fig. 3: Trigger Signal A is still 1)
9. There are three active transconductance circuits 130, 140, 150 (step 211). So, adaptive control unit 110 has to start counting (step 205) again from zero in order to deactivate one transconductance circuit 130, 140, 150 if there is no detected clipping signal 132, 142, 152.
   a. If there is no difference between output voltage signal 121 and reference voltage 122, no transconductance circuit 130, 140, 150 will be saturated and they will not generate clipping signal 132, 142, 152.
   b. When clipping signal 132, 142, 152 is not detected (step 213) in adaptive control unit 110 , it increments the counter (step 206).
   c. When the counter is equal to predefined value (step 214) :
      i. If the number of active transconductance circuits 130, 140, 150 is higher than one (step 215), adaptive control unit 110 will deactivate one transconductance circuit 130, 140, 150 (step 204) which was on for the longest time by reading the FIFO and deletes the index of deactivated transconductance circuit 130, 140, 150. (Fig. 3: CMC #2 is the slice to be deactivated)
10. There are two active transconductance circuits 130, 140, 150 (step 211). So, adaptive control unit 110 has to start counting (step 205) again from zero in order to deactivate one transconductance circuit 130, 140, 150 if there is no detected clipping signal 132, 142, 152.
   a. If there is no difference between output voltage signal 121 and reference voltage 122, no transconductance circuit 130, 140, 150 will be saturated, and they will not generate clipping signal 132, 142, 152.
   b. When clipping signal 132, 142, 152 is not detected (step 213) in adaptive control unit 110, it increments the counter (step 206).
   c. When the counter is equal to predefined value (step 214) :
      i. If the number of active transconductance circuits 130, 140, 150 is higher than one (step 215), adaptive control unit 110 will deactivate one transconductance circuit 130, 140, 150 (step 204) which was on for the longest time by reading the FIFO and deletes the index of deactivated transconductance circuit 130, 140, 150. (Fig. 3: CMC #5 is the slice to be deactivated)
11. There is one active transconductance circuit 130, 140, 150 (step 211). So, adaptive control unit 110 waits for clipping signal 132, 142, 152 to activate one more transconductance circuit 130, 140, 150. (Fig. 3: CMC #1 is the only active slice)

### List of references

- 100: ethernet physical layer transceiver
- 110: adaptive control unit
- 120: first circuit
- 121: output voltage
- 122: reference voltage
- 130: transconductance circuit
- 131: enable signal
- 132: clipping signal
- 133: compensation current signal
- 134: compensation current signal
- 140: transconductance circuit
- 141: enable signal
- 142: clipping signal
- 150: transconductance circuit
- 151: enable signal
- 152: clipping signal
- 160: media dependent interface (MDI)
- 200: method for adaptive common-mode disturbance compensation
- 201: method start
- 202: activate transconductance receiver
- 203: activate one more transconductance receiver
- 204: deactivate transconductance receiver
- 205: start counter
- 206: increment counter
- 207: trigger interrupt signal B
- 208: set value `maximum number of active slices'
- 209: trigger interrupt signal A
- 211: more than 1 active transconductance receiver?
- 212: clipping signal detected?
- 213: clipping detected?
- 214: counter equal to predefined value?
- 215: active transconductance receivers higher than one?
- 216: total available transconductance receiver active?
- 217: number of active transconductance circuits higher than counter 'Maximum Number of Slices Activated'?
- 218: predefined threshold exceeded?

## Claims

1. Method for adaptive common-mode disturbance compensation in ethernet physical layers, comprising the steps of:
measuring a voltage signal of a media dependent interface of the ethernet physical layer;
generating an output voltage signal based on the measured voltage signal of the media dependent interface;
providing the output voltage signal and a reference voltage signal to at least two identical transconductance circuits, which are connected together to the media dependent interface, wherein each transconductance circuit:
compares the output voltage signal with the reference voltage signal,
generates a compensation current signal based on the result of the comparison of the output voltage signal with the reference voltage signal, and
provide the compensation current signal to the media dependent interface; and
selectively enabling and/or disabling one or more of the at least two transconductance circuits, until the output voltage signal equals to the reference voltage signal.

2. Method according to claim 1,
wherein an enabled transconductance circuit generates a clipping signal when the transconductance circuit is saturated, wherein this clipping signal is used to enable a further transconductance circuit, which is currently disabled.

3. Method according to claim 1 or claim 2,
wherein the transconductance circuit is a feedback transconductance amplifier that compares the output voltage signal with the reference voltage signal and generates the compensation current signal.

4. Method according to any of claims 1 to 3,
further comprising the step of defining a threshold number of enabled transconductance circuits and generating an event or storing an event in a database for later readout if the number of enabled transconductance circuits exceeds threshold number, wherein the threshold number is smaller than the total number of available transconductance circuits.

5. Method according to any of claims 1 to 4,
wherein at least one transconductance circuit is enabled at all times.

6. Method according to any of claims 1 to 5,
wherein each transconductance circuit has a unique index and the index of enabled transconductance circuits are stored in a FIFO register according to their sequence of enabling.

7. Method according to any of claims 1 to 6,
wherein an interrupt signal is generated if the number of enabled transconductance circuits is equal to the number of available transconductance circuits.

8. Method according to any of claims 1 to 7,
further comprising the step of starting a counter after a transconductance circuit has been enabled and disabling a transconductance circuit if no further transconductance circuit is enabled until the counter expires and at least two transconductance circuits are enabled.

9. An ethernet physical layer transceiver with adaptive common-mode disturbance compensation in ethernet physical layers, comprising:
a first circuit connected to a media dependent interface of the ethernet physical layer and configured
to measure a voltage signal across the media dependent interface and
to generate an output voltage signal based on the measured voltage signal;
at least two identical transconductance circuits, which are connected in parallel to the media dependent interface and to the first circuit, wherein the transconductance circuits are each configured to:
receive the output voltage signal from the first circuit and compare the output voltage signal with a reference voltage signal,
generate a compensation current signal based on the result of the comparison of the output voltage signal with the reference voltage signal,
provide the compensation current signal to the media dependent interface, and
generate clipping signal when the transconductance circuit is saturated,
each transconductance circuit further comprising an enable input for being selectively enabled or disabled;
an adaptive control unit connected to all transconductance circuits for receiving clipping signals from and sending enable/disable signal to respective transconductance circuits, wherein the adaptive control unit is configured to implement the method according to any of claims 1 to 8 by
adjusting the number of active transconductance circuits by sending enable/disable signals to selected transconductance circuits.

10. Ethernet physical layer transceiver according to claim 9,
wherein the transconductance circuit is a feedback transconductance amplifier.
